# EUROPEAN PATENT APPLICATION

(11) **EP 2 662 844 A2**
(43) Date of publication of application: **13.11.2013**
(21) Application number: 13167347.7
(22) Date of filing: 10.05.2013
(51) Int. Cl.: G08B 13/14, G01R 31/40

(54) **Alarm apparatus for connection to a photovoltaic array**

(30) Priority: 11.05.2012 GB 201208324; 25.05.2012 GB 201209257; 14.08.2012 GB 201214496
(71) Applicant: Area Energy Limited, Durley Hampshire SO32 2AP (GB)
(72) Inventor: Warren, Royston David, Durley, Hampshire SO32 2AP (GB)
(74) Representative: Robinson, Simon John

(57) **Abstract**

Alarm apparatus for connection to a photovoltaic array, the apparatus comprising a signal processor arranged to monitor solar energy generated electrical power output from the photovoltaic array, the signal processor arranged to detect when an irregular power output is sensed from the photovoltaic array, and the apparatus arranged to cause an alarm condition to be activated if the irregular power output is sensed.

## Description

### Technical Field

The present invention relates generally to photovoltaic arrays.

### Background

With the recent introduction of easily fitted alternating current (AC) inverters being connected to DC solar photovoltaic panels, the likelihood of theft of the panels has become very probable especially in isolated and rural areas.

There is known an alarm system which comprises security tags/sensors which are attached to each of the panels. The sensors are arranged to send a wireless signal to a signal-receiving base unit, which on receipt of an alarm signal from one or sensors is operative to activate an alarm. However, installation of this alarm system requires a technician to clamber dangerously on a roof (in all weathers). The tags/sensors are also cumbersome to install

Despite their significant advantages in terms of green energy, photovoltaic panels can present a particular risk in the event of the outbreak of fire in a building in which the panels are installed. We have realised that it would be advantageous to provide improved safety measures in such an eventuality.

With the advent of DIY-installable solar photovoltaic panels and parts safety issues can arise as a result of incorrect installation of electrical connections and associated wiring, or indeed incorrect components being fitted. Incorrect installation can lead to a heightened risk of electrocution. We have realised that it would be advantageous to provide improved safety measures in that regard.

Despite the prevalence of solar photovoltaic installations, fire services are unsure as to how to best to deal with incidences of fires in buildings with photovoltaic panels. This is because the photovoltaic panels cannot be de-energised, and so remain live whilst solar energy impinges on the panels, thus presenting a significant danger to fire service crews. This can often result in fire service crews allowing the first to go unchecked, with disastrous results for the property concerned.

### Summary

According to a first aspect of the invention there is provided an alarm apparatus for connection to a photovoltaic array, the apparatus comprising a signal processor arranged to monitor solar energy generated electrical power output from the photovoltaic array, the signal processor arranged to detect when an irregular power output is sensed from the photovoltaic array, and the apparatus arranged to cause an alarm condition to be activated if the irregular power output is sensed.

The signal processor may be arranged to monitor waveform characteristics of the power output.

The expression 'photovoltaic array' includes both a singular and collective meaning, and so covers both a single photovoltaic unit as well as multiple (physically distinct) photovoltaic units/modules.

The signal processor may be arranged to determine the irregular power output on the basis of comparing the sensed frequency or wavelength of the output to predetermined criteria. The predetermined criteria may comprise a threshold value or value range of frequency or wavelength which is indicative of an irregular power signal. The predetermined criteria may comprise a threshold value or value range of magnitude of the power output. The predetermined criteria may comprise a combination of magnitude, frequency and/or wavelength values indicative of an irregular power signal. Alternatively, or in addition, the signal processor may be arranged to determine when the power output does not confirm to expected power output characteristics (which are indicative of normal/usual operation).

The irregular power output, characterised by the predetermined criteria, may be indicative of a photovoltaic module of the photovoltaic array having been removed or disconnected from the array.

The irregular power output may be indicative of a 'violent' drop or fluctuation in the regular, or expected, operational output parameters.

The irregular power output, characterised by the predetermined criteria, may be indicative of (sudden or marked) sub-optimal operational efficiency of the photovoltaic array.

The apparatus may be arranged to be connected to power output wiring from the photovoltaic array.

The apparatus may be arranged to be connected to power output wiring from the photovoltaic array, which wiring is internal of the structure to which the array is installed. For example, where the array is installed on a building structure, such as a house, the apparatus is conveniently connectable to wiring which is inside the house.

The apparatus is preferably arranged for connection between the photovoltaic array and an inverter module.

The apparatus may comprise a transmitter unit, and may further comprise a base station for receiving signals from the transmitter unit (by either wired or wireless connection therebetween). The transmitter unit may be arranged to be connected to power output wiring from the photovoltaic array. The signal processor may be housed in either the base station or the transmitter unit.

The apparatus may be arranged to send (either directly or via an intermediary component) an alarm activation signal to an alarm system. The alarm system may be arranged to emit an audio or visual alarm. The alarm system or the apparatus may be capable of emitting an alarm status signal, for example transmitted over an air interface, which is arranged to be received by a remotely located receiver device (such as a mobile telephone, for example). The alarm system may comprise an intruder alarm.

The apparatus may be viewed as an anti-theft device for a photovoltaic array.

The photovoltaic array may comprise a plurality of photovoltaic modules.

The apparatus may comprise a heat/smoke detector, arranged to be installed at or in a structure to which the photovoltaic array is installed, and on detection of smoke and/or heat, the detector arranged to issue a control signal to a switch which is operative to disconnect the power output from the photovoltaic array. The switch may be arranged to disconnect a power output from the photovoltaic array to an inverter. The switch may be arranged to be located intermediate of the photovoltaic array and the inverter. The switch may conveniently be incorporated with the transmitter unit of the apparatus (which monitors the power output from the array).

The apparatus may comprise a sensor to monitor the electrical potential of one or more external surfaces of the array to determine whether surfaces are electrically live. If that is determined to be the case, the apparatus is arranged to disconnect the power output from the array, and cause an alarm to be activated. The apparatus may comprise a switch which is operable to disconnect the output power supply from the array in the event of the external surface(s) of the array being determined to be live.

According to a second aspect of the invention there is provided a safety switch apparatus for connection to a photovoltaic array system, the apparatus comprising at least one of a sensor to issue a control signal if heat and/or smoke is detected (which is caused by a fire), and a live detector to sense whether one or more external surfaces of the photovoltaic array has an electric potential beyond a threshold value, and if so, a control signal is emitted, the apparatus further comprises a switch device, the switch device arranged to be capable of disconnecting a power output from the array on receipt of a control signal.

The safety switch apparatus may comprise a direct current contactor.

The safety switch apparatus may further comprise a second switch device which acts on an alternating current output of an inverter to selectively control AC output from the inverter. The second switch device may comprise an AC connector. The second switch device is controlled by the control signal.

The control signal is preferably arranged to cause switching of the (first) and second switch devices so as to disconnect DC output from the array and disconnect AC output from the inverter.

The safety switch apparatus preferably comprises a control unit to issue a first control signal to control the first switch device and to issue a second control signal to control the second switch device. The control unit may be arranged to disconnectingly activate the second switch device prior to activating the first switch device. The control unit may be arranged to reconnect the power output, by first connectingly activating the first switch device and then connectively activating the second switch device.

The safety switch apparatus may be arranged to issue an alarm signal in the event of a control signal being emitted, which alarm signal causes an alarm to be activated.

The switch device is arranged to be installed proximal to the array.

The safety switch may be viewed as being arranged to effect an automated cut-off of power output from the array.

The apparatus may include a transmitter to issue an alarm status signal.

The apparatus is preferably retrofittable to a pre-installed solar array system.

According to a third aspect of the invention there is provided a disablement apparatus for energy generating photovoltaic units to selectively disable each photovoltaic unit connected to the apparatus in response to a control signal, the disablement apparatus comprising at least one switch which is associated with one or a sub-group of photovoltaic units of a photovoltaic installation, the or each switch connected to an electrical output of a photovoltaic unit (or sub-group of photovoltaic units), and the switch operative to selectively connect and disconnect electrical power generated by each unit (or group of units) to the output.

Preferably a switch is provided for each photovoltaic unit so as to disable each unit individually.

Preferably each photovoltaic unit comprises a photovoltaic panel.

Preferably, with the photovoltaic unit (or sub-group of photovoltaic units) in a disabled condition, the switch is operated to isolate the associated photovoltaic unit or sub-group from an adjacent unit of the installation.

Each switch may be responsive to a control signal which is automatically issued on detection of smoke or heat generated from a fire. In addition, or alternatively, each switch may be responsible to a control signal which is issued from a manual control device. The manual control device may be a hand-portable device. The manual control device may communicate with the switches by way of a wired or wireless signal, other directly or indirectly (for example via an intermediate node).

The manual control device may be confirmed to provide a status output indicative of the at least one switch having caused the at least one photovoltaic unit to have been disabled. The status output may comprise a visual and/or audible signal.

Advantageously, the manual control device allows the disablement apparatus to be remotely controlled.

According to a fourth aspect of the invention there is provided an installed system comprising at least one of the first, second or third aspects of the invention.

The apparatus may comprise one or more features of the embodiment(s) in the detailed description and/or the drawings.

### Brief Description of the drawings

Various embodiments of the invention will now be described, by way of example only, with reference to the following drawings in which:
**Figure 1** is a block diagram showing a solar array alarm system,
**Figure 2** is a block diagram showing a solar array system, and
**Figure 3** is a schematic diagram of a solar array system.

### Detailed Description

There is now described a photovoltaic array alarm apparatus 1, which, as will be described in more detail below, is operative to effect various safety and security functionalities in relation to one or more installed array of photovoltaic modules 3. The apparatus not only serves as an anti-theft device, it also serves to ensure safety against fires and photovoltaic modules becoming electrically live.

Broadly, the apparatus 1 comprises a monitor 2 which is connectable to an output power supply from the array 3. The monitor 2 is operative to monitor the characteristics of the output signal, such as magnitude, wavelength and/or frequency, so as to determine when an irregular output signal is detected. This is achieved by the monitor comparing the sensed output signals with (stored) predetermined criteria. In usual operation of the array, one expects a varying DC output from the array- which correlates to the change in radiant energy received by the array over the course of a day, a year. Such a 'regular' signal has particular magnitude, wavelength/frequency characteristics. We have realised that if one or more modules or subarrays from the array is/are removed/disconnected, the output power signal becomes highly erratic, and is very different to what one expect to see in normal operation (with all modules present and operating correctly).

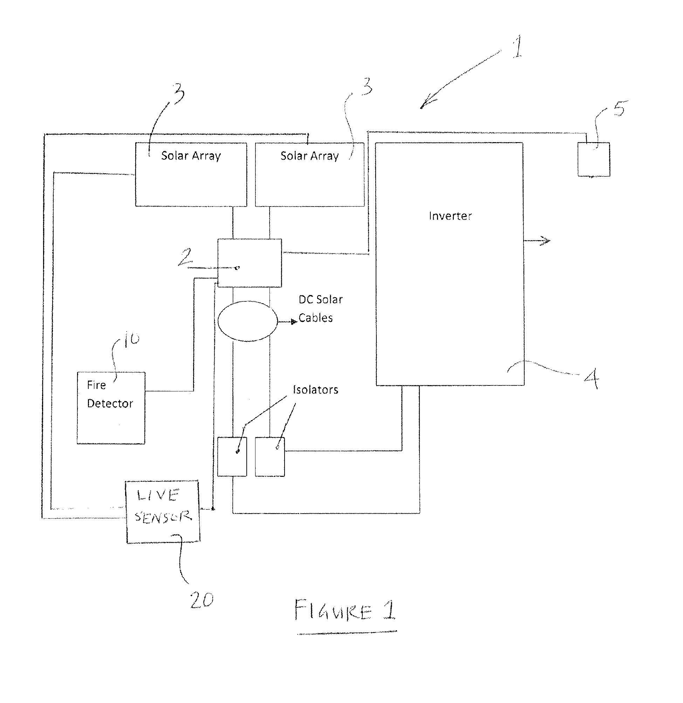

The monitor 2 comprises a unit which is readily connectable to wiring carrying direct current power from the photovoltaic array. Conveniently, the wiring is located internally of the building on which the array is attached, and so the need to access an external roof structure (with the inherent safety issues) to install the apparatus 1 is avoided. The complete installation procedure of the apparatus 1 can be effected within the building. As is shown in Figure 1, the monitor 2 is attached at a location which is intermediate of the array and a DC to AC inverter 4. The inverter converts the direct current (DC) from the solar panels into alternating current (AC) which can be used in the home, or can be fed into the grid. Wiring from each of the modules of the array is electrically connected to the monitor. At an output side of the monitor, there is connected wiring which connects through to the inverter 4. The monitor 2 preferably monitors the output power supply in a non-invasive manner which does not, or does not appreciably, affect the magnitude of the power supply received by the inverter 4.

The monitor 2 includes a memory which stores data indicative of predetermined criteria, against which the sensed output power signal is compared by way of a signal processor. For example, the criteria may include values or ranges of values. Of magnitudes, frequencies/wavelengths, which are indicative of irregular or abnormal power supply signal should the monitor. For example, the criteria may require that for the sensed power output signal to be determined as irregular, the magnitude thereof must fall below a predetermined threshold. Alternatively, or in addition, the criteria may comprise values, or ranges of values, which relate to magnitude, frequency, wavelength, which is indicative of a regular/expected power output signal, or the signature/footprint of an expected power supply signal. In this latter case, should the signal processor determine that the sensed power supply signal lies outside those parameters, the sensed power signal is determined as being irregular/abnormal.

In the event that the monitor 2 determines an irregular a power supply output from the array, the apparatus is arranged to cause an alarm to be raised. In the embodiment shown, the apparatus 1 further comprises a base station which is hardwire connected to the monitor. On receipt of an alarm status signal from a transmitter of the monitor, the base unit 5 is arranged to cause an alarm to be activated so as to notify interested parties (such as the proprietor or resident of the building) that a module or sub-array of the array has been disconnected or removed. The base unit 5 may be provided with suitable audio and or visual warnings. In addition, or alternatively, the base unit may be arranged to notify an interested party remote from the apparatus, by way of a signal sent to user communications device, such as a mobile telephone. In one embodiment, the base unit may be connected to an existing intruder alarm system.

In an alternative embodiment, the connection between the monitor and the base unit may be by way of a wireless, or air-interface, connection.

By alerting interested parties to the detection of the presence of an irregular power output signal, the interested party/parties is/are notified that part or all of the installed photovoltaic array my be being removed. The interested party/parties can then take any mitigating action, such as contacting the police.

In the embodiment shown, there is also provided fire detection functionality. In that regard the apparatus 1 comprises a smoke/heat detector 10, which is connected to the monitor. The monitor comprises a switch which is arranged to selectively connect the power supply from the array to the inverter, in response to a control signal received from the fire detector. The fire detector 10 is arranged to detect fire within the structure on which the array is installed. If fire is detected, the detector is operative to send a signal to the switch in the monitor so as to disconnect the output power supply from the photovoltaic array to the inverter. In this way, highly advantageously the risk of an electrical fire related to the power generated from the array is significantly reduced. Also, on the detector determining that a fire is present, suitable audio or visual alarm may be activated to alert those inside the building, and/or the relevant authorities, such as the fire services. It will be appreciated that communication between the fire detector and the monitor may be by way of a wireless, or air-interface, connection. This automatic shutdown advantageously ensures that output power wiring downstream of the array is no longer live, and so no longer presents a electrocution hazard, for example to fire service crews. Cutting of the power in this way also eliminates the risk of electrical fires resulting therefrom.

The apparatus 1 further includes the safety functionality of a live detector/sensor 20, which is operative to monitor the electrical potential of external surfaces of the array, such as the surrounding metal frames of the array. In the event of a faulty connection, the external surfaces of the array may become live, and so present an electrical shock hazard to someone inadvertently touching said external surfaces. The live sensor is electrically connected to the respective external surfaces of the array, and in particular electrically conductive frame(s) of the array. On detection of a live electrical signal from one or more of the external surfaces, the sensor is operative to transmit a control signal to the switch of the monitor 2, and to cause the switch to discontinue the power supply to the inverter 4. On receipt of the signal from the live sensor, the transmitter of the monitor may be arranged to cause an alarm signal to be emitted so as to notify interested parties (such as the residents(s) and/or owner(s)) of the building of the situation. A technician can then be instructed to repair the fault, and in the meantime, inadvertent contact with the live array, and in particular a surrounding (metal) frame of the array, can be avoided. Determination of one or more of the external surfaces of the array being live may be effected by way of comparison of the potential of the external surfaces of the array to a threshold value, and whether the sensed potential is beyond the threshold value.

The monitor 2 is preferably connected as close as possible to the array. The apparatus is conveniently retrofittable to existing installed solar array systems, however, the apparatus may be incorporated as an integral component of a solar array system.

It will be appreciated that the apparatus described above has the multiple functionality of anti-theft, and automated cut-off and alarm activation in the event of either detected fire and/or external parts of the array becoming live. It will be appreciated, however, that in alternative embodiments only one or two of those functionalities may be provided, as required by the end user. In the event that one or both of the live detection and fire detection functionalities are included, but not the anti-theft functionality, the apparatus module which is connected to the power output includes a switch device to selectively disconnect power output from the array, and preferably a transmitter to issue an alarm status signal.

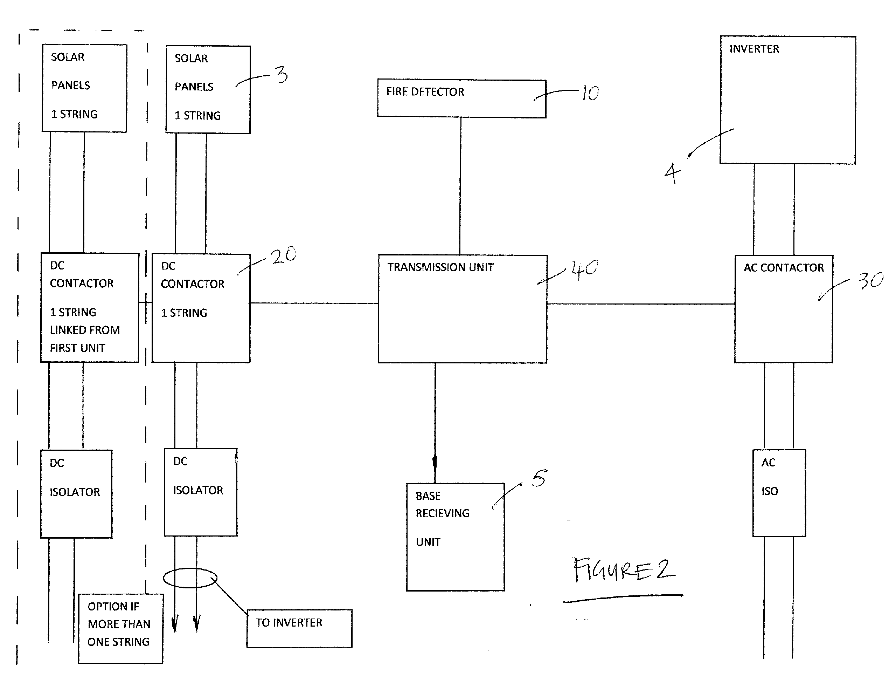

With reference to Figure 2 there is shown a second embodiment in which like reference numerals are used to denote the same or similar components. The embodiment shown in Figure 2 includes an automated power shut-off in the event that fire is detected by the fire detector 10. To that end a safety switch apparatus comprises a DC contactor switch device 20 and an AC contactor switch device 30. Both switch devices are contacted by respective control signals output by the transmission unit 40. The DC contactor 20 is connected to a DC power output from the solar panels 3. Where the photovoltaic array comprises multiple strings, each string is provided with a DC contactor. The AC contactor device 30 is connected to an AC output of the inverter 4. Each of the contactor switch devices is operative to control power DC and AC output respectively. In the event that fire is detected the transmission unit 40 is operative to first issue a control signal to the AC contactor 30 so as to disconnect AC power output from the inverter. The transmission unit 40 is then operative to send a control signal to the DC contactor 20 so as to disconnect DC power output from the panels 3. By activating the connectors in this sequence disconnection of the photovoltaic power output is achieved safely. This sequence ensures that all but a small amount of current enabling the DC side to be disconnected (using switch equipment having a much lower current rating). In order to reconnect power output the DC connector is first connectingly activated and then the AC connector is connectingly activated. The transmission unit 4 includes suitable stored instructions (for example in the form of software or firmware to effect the disconnection/connection process).

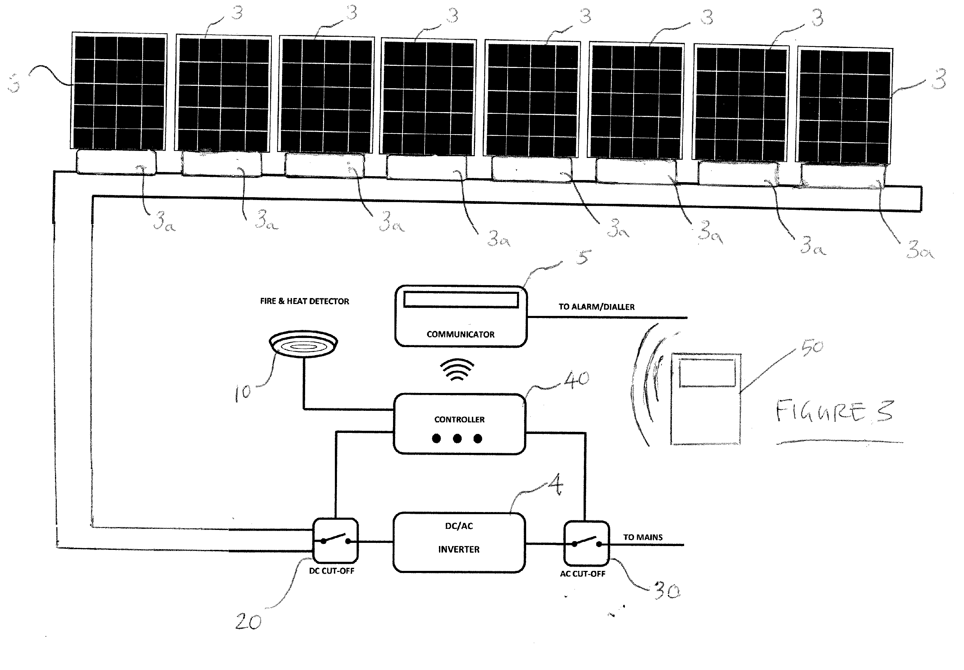

Reference is now made to Figure 3 which shows a safety switch apparatus for a photovoltaic array system (which may be viewed as an enhanced embodiment of Figure 2). The embodiment shown in Figure 3 includes the feature of each of the photovoltaic panels 3 comprising a switch unit 3a which is operative to selectively isolate each panel and remove accumulated DC voltage in the circuitry which connects the panels together. Each switch unit 3a comprises either an integrated/built-in switch (either electronic or mechanical), or each switch unit 3a may comprise a retro-fitted device, such as a contactor or relay. Each switch unit is operative to selectively connect and disconnect the output of one panel to an adjacent panel (the panels being connected in series) and thereby isolate electrical generation from each panel.

Each of the switch units 3a is controllable by way of hand wired or wireless signals from the controller 40.

When each of the switch units is in an in-use condition electrical energy generated in a panel is allowed to flow into the circuitry which connects the panel output 3 together. This then allows the electricity generated to flow towards the inverter 4. In the event that the fire/heat detector 10, or another such detector located in or associated with the property on which the panels are installed, the controller 40 is operative to output a control signal. The control signal is first operative to cause the AC cut-off switch 30 to switch to a disconnected condition. The control signal is then operative to cause the cut-off switch 20 to switch to a disconnected condition. The control signal is then operative to cause each of the switch units 3a to switch to a disconnected condition. In so doing generated electricity is no longer able to flow into the circuitry and so accumulated DC is no longer present in the circuitry. Each panel becomes isolated from each of the other panels. A visual and/or audible signal may be activated once each of the sequence has been effected so that it is known that there is no risk from accumulated DC voltage. It is now safe for fire crews to apply water to the property without risk of any accumulated DC voltage being conducted to the crew. In addition/alternatively, the switch units 3a being automatically switched to a disconnected state, this may be achieved by way of a hand-held device 50 which is configured to communicate with the controller 40, so as to initiate the switching off of the AC cut-off, the DC cut-off and each of the switch units 3a. Such a device 50 could conveniently be used by fire crews attending the fire at the property so as to allow the crew to switch the PV system off so that the fire incident can be attended to with minimal risk of electrocution. The hand-held device 50 comprises an input device (for example, one or more buttons) and a visual/audible output (for example, including a visual display). Once the controller 40 has determined that each of the AC cut-off, the DC cut-off and each of the switch units 3a has been switched to an out-of-use condition, a signal from the controller 40 is then sent to the hand-held unit 50. Signal communication between the hand-held device 50 and the controller 40 is enabled by suitable encoding/addressing. Advantageously, the hand-held unit 50 allows the photovoltaic system to be de-powered remotely.

The arrangement of switch units 3a advantageously ensures that the PV generation system is powered down and does not remain live and a constant danger.

It will be appreciated that use of the switches 3a may be beneficially used even without use of the DC cut-off switch and the AC cut-off switch, so, the panels (included whether by way of inclusion at time of manufacture or by retrofit) still presents a significant advantage in terms of the safety benefit afforded. However, use of the DC cut-off switch and the AC cut-off switch provide additional reassurance.

It will be appreciated that the arrangement of Figure 2 may be incorporated with the arrangement of Figure 1, and that the arrangement of Figure 3 may be incorporated with the arrangement of Figure 1.

## Claims

1. Alarm apparatus for connection to a photovoltaic array, the apparatus comprising a signal processor arranged to monitor solar energy generated electrical power output from the photovoltaic array, the signal processor arranged to detect when an irregular power output is sensed from the photovoltaic array, and the apparatus arranged to cause an alarm condition to be activated if the irregular power output is sensed.

2. Alarm apparatus as claimed in claim 1 in which the signal processor is arranged to monitor waveform characteristics of the power output.

3. Alarm apparatus as claimed in claim 1 or claim 2in which the signal processor is arranged to determine the irregular power output on the basis of comparing the sensed frequency or wavelength of the output to predetermined criteria.

4. Alarm apparatus as claimed in any preceding claim which is arranged to be connected to power output wiring from the photovoltaic array.

5. Alarm apparatus as claimed in any preceding claim which is arranged for connection between the photovoltaic array and an inverter module.

6. Alarm apparatus as claimed in any preceding claim which comprises a transmitter unit, and may further comprise a base station for receiving signals from the transmitter unit.

7. Alarm apparatus as claimed in any preceding claim which is arranged to send an alarm activation signal to an alarm system.

8. Alarm apparatus as claimed in any preceding claim which comprises a heat/smoke detector, arranged to be installed at or in a structure to which the photovoltaic array is installed, and on detection of smoke and/or heat, the detector arranged to issue a control signal to a switch which is operative to disconnect the power output from the photovoltaic array.

9. Alarm apparatus as claimed in any preceding claim which comprises a sensor to monitor the electrical potential of one or more external surfaces of the array to determine whether surfaces are electrically live.

10. A safety switch apparatus for connection to a photovoltaic array system, the apparatus comprising at least one of a sensor to issue a control signal if heat and/or smoke is detected (which is caused by a fire), and a live detector to sense whether one or more external surfaces of the photovoltaic array has an electric potential beyond a threshold value, and if so, a control signal is emitted, the apparatus further comprises a switch device, the switch device arranged to be capable of disconnecting a power output from the array on receipt of a control signal.

11. The safety switch apparatus of claim 10 comprising a direct current contactor.

12. The safety switch apparatus of claim 10 or claim 11 arranged to issue an alarm signal in the event of a control signal being emitted, which alarm signal causes an alarm to be activated.

13. A disablement apparatus for energy generating photovoltaic units to selectively disable each photovoltaic unit connected to the apparatus in response to a control signal, the disablement apparatus comprising at least one switch which is associated with one or a sub-group of photovoltaic units of a photovoltaic installation, the or each switch connected to an electrical output of a photovoltaic unit (or sub-group of photovoltaic units), and the switch operative to selectively connect and disconnect electrical power generated by each unit (or group of units) to the output.

14. Apparatus as claimed in claim 13 in which a switch is provided for each photovoltaic unit so as to disable each unit individually.

15. Apparatus as claimed in claim 13 or 14 in which with the photovoltaic unit (or sub-group of photovoltaic units) in a disabled condition, the switch is operated to isolate the associated photovoltaic unit or sub-group from an adjacent unit of the installation.
